# EUROPÄISCHE PATENTANMELDUNG

(11) **EP 3 531 807 A1**
(43) Veröffentlichungstag der Anmeldung: **28.08.2019**
(21) Anmeldenummer: 18174837.7
(22) Anmeldetag: 29.05.2018
(51) Int. Cl.: H05K 3/22, H05K 1/14, H01R 12/59, H01R 43/02

(54) **ANORDNUNG MIT EINER FLEXIBLEN LEITERPLATTE**

(30) Priorität: 26.02.2018 DE 102018104250
(71) Anmelder: enmech GmbH, 69469 Weinheim (DE)
(72) Erfinder: Wittchen, Markus, 12157 Berlin (DE); Pohlke, Martin, 13509 Berlin (DE); Preradovic, Oliver, 13629 Berlin (DE); Wurst, Jürgen, 14195 Berlin (DE)
(74) Vertreter: Wesch, Arno

(57) **Zusammenfassung**

Eine Anordnung, umfassend eine flexible Leiterplatte (6) mit Leiterbahnen (7, 7a, 7b) und ein Stromlenkungsmittel, welches mit der flexiblen Leiterplatte (6) an einem Anbindungsbereich (9) verbunden ist, wobei das Stromlenkungsmittel mindestens einen Eingangsanschluss (2) für eine erste Leiterbahn (7a) aufweist, wobei das Stromlenkungsmittel einen Ausgangsanschluss (3) für eine zweite Leiterbahn (7b) aufweist und wobei die beiden Leiterbahnen (7a, 7b) durch das Stromlenkungsmittel miteinander elektrisch leitend verbindbar oder verbunden sind, löst die Aufgabe, eine flexible Leiterplatte anzugeben, bei welcher Leiterbahnanschlüsse, die an verschiedenen Orten der flexiblen Leiterplatte positioniert sind, problemlos miteinander elektrisch leitend verbindbar sind.

## Beschreibung

Die Erfindung betrifft eine Anordnung mit einer flexiblen Leiterplatte.

Aus dem Stand der Technik sind bereits sogenannte FPCs bekannt. Die Abkürzung FPC steht für "Flexible Printed Circuit" und wird in der Fachwelt zur Bezeichnung einer flexiblen Leiterplatte verwendet.

Zur Fertigung einer solchen Leiterplatte werden auf einer flexiblen Folie aus Kunststoff, die als Schaltungsträger dient, Leiterbahnen aufgebracht oder durch ein subtraktives Verfahren erstellt. Die Leiterbahnen bestehen üblicherweise aus elektrisch leitendem Material z.B. Kupfer. Einige Leiterbahnen münden in Kontaktierungsflächen oder Leiterbahnanschlüsse, die üblicherweise am Rand der Folie oder in laschenartigen Auskragungen der Folie angeordnet sind oder sich innerhalb der Leiterplatte befinden.

Es sind einlagige flexible Leiterplatten bekannt, welche eine Folie mit Leiterbahnen aufweisen. Des Weiteren sind mehrlagige flexible Leiterplatten bekannt.

Aus dem Stand der Technik sind auch sogenannte PCBs bekannt. Die Abkürzung PCB steht für "Printed Circuit Board" und wird in der Fachwelt zur Bezeichnung einer Leitertafel, Leiterplatte, Leiterkarte, Platine oder gedruckten Schaltung verwendet.

Ein solches Produkt ist ein Träger für elektronische Bauteile, wie beispielsweise ICs, passive und aktive Bauteile. Eine PCB muss nicht ausschließlich einen Stecker tragen. PCBs können auch Träger von elektronischen Bauteilen sein, ein Stecker sitzt dann an einer anderen Stelle. Auf einer PCB sind Bauteile wie Widerstände, Kondensatoren und/oder ICs vorgesehen, die zur Verbesserung einer Funktionalität benötigt werden. Eine PCB kann auch ein Träger für elektronische Stecker mit Stiften, wie beispielsweise sogenannte PTHs ("Pin Through Hole") sein. Die Stifte der Stecker werden üblicherweise in Stiftaufnahmen in der Leitertafel hineingesteckt.

Aus dem Stand der Technik sind auch sogenannte Starrflex-Leiterplatten bekannt, welche aus starren und flexiblen Leiterplatten bestehen, die unlösbar miteinander verbunden sind. Starrflex-Leiterplatten sind statisch und dynamisch mechanisch belastbar.

Leiterbahnanschlüsse einer flexiblen Leiterplatte können in räumlicher Hinsicht so ungünstig voneinander entfernt liegen, dass andere Leiterbahnen auf der flexiblen Leiterplatte überquert werden müssten. Dies würde zu unübersichtlichen Leiterbahnkreuzungen führen. In der Praxis besteht häufig die Notwendigkeit, Leiterbahnen zu kreuzen.

Der Erfindung liegt daher die Aufgabe zu Grunde, eine flexible Leiterplatte anzugeben, bei welcher Leiterbahnanschlüsse, die an verschiedenen Orten der flexiblen Leiterplatte positioniert sind, problemlos miteinander elektrisch leitend verbindbar sind.

Die vorliegende Erfindung löst die zuvor genannte Aufgabe durch die Merkmale des Patentanspruchs 1.

Erfindungsgemäß ist erkannt worden, dass ein flächiges Stromlenkungsmittel derart mit der flexiblen Leiterplatte verbindbar ist, dass dieses potentielle Leiterbahnkreuzungen auf der flexiblen Leiterplatte entflechtet. Das Stromlenkungsmittel wirkt insoweit als Umlenkungsmittel.

Konkret ist erkannt worden, dass eine nachträgliche Verbindung zwischen einer flexiblen Leiterplatte und einem Stromlenkungsmittel möglich ist. Die Anordnung wird insoweit nicht bereits als Starr-Flex-Leiterplatte hergestellt, sondern eine flexible Leiterplatte wird nachträglich bedarfsgerecht mit einem Stromlenkungsmittel versehen.

Die flexible Leiterplatte kann als einlagiger oder als mehrlagiger Schaltungsträger hergestellt werden.

Eine erste Leiterbahn könnte mit einer zweiten Leiterbahn elektrisch leitend verbindbar oder verbunden sein, ohne dass eine weitere Leiterbahn der flexiblen Leiterplatte durch die elektrische Verbindung gekreuzt oder überquert ist. Hierdurch werden Leiterbahnkreuzungen auf einer flexiblen Leiterplatte vermieden. Bevorzugt sind auf der flexiblen Leiterplatte keine Leiterbahnkreuzungen vorhanden.

Das Stromlenkungsmittel könnte als Leitertafel ausgestaltet sein, welche biegesteifer als die flexible Leiterplatte ist. Mit Hilfe von ein- oder mehrlagigen Leitertafeln (PCBs) ist eine Entflechtung von Leiterbahnkreuzungen möglich, wenn die Leitertafel mittels eines Verbindungsverfahrens an die flexible Leiterplatte elektrisch angebunden und mechanisch fixiert wird. Weiter kann eine PCB auch Bauteile enthalten, die die Funktion der gesamten Anordnung unterstützen.

Die Leitertafel könnte Stiftaufnahmen aufweisen, wobei mindestens eine erste Stiftaufnahme mit einem Eingangsanschluss der Leitertafel elektrisch leitend verbunden ist und wobei mindestens eine zweite Stiftaufnahme mit einem Ausgangsanschluss der Leitertafel elektrisch leitend verbunden ist. So kann eine Leitertafel oder PCB auch als Träger für eine elektrische Kontaktierung, wie z.B Pin Through Hole (THT) Stecker, dienen.

Das Stromlenkungsmittel könnte als weitere flexible Leiterplatte ausgestaltet sein. In einem Verbund zweier flexibler Leiterplatten wird eine Leitertafel oder PCB durch eine geeignete ein- oder mehrlagige flexible Leiterplatte oder FPC ersetzt.

Das Stromlenkungsmittel könnte durch eine stoffschlüssige Verbindung mit der flexiblen Leiterplatte verbunden sein. Zur Herstellung einer stoffschlüssigen Verbindung könnten Verbindungsverfahren wie Löten, Kleben, Bonden, Schweißen o.ä. eingesetzt werden. Hierbei können Laseranwendungen zum Abtragen von Folie entfallen.

Das Stromlenkungsmittel könnte einen Stecker tragen, welcher in das Stromlenkungsmittel reversibel oder irreversibel eingesteckt ist. So kann eine Leitertafel oder PCB auch als Träger für eine elektrische Kontaktierung, wie z.B Pin Through Hole Stecker, dienen. Das Stromlenkungsmittel könnte zusätzlich oder alternativ elektronische Bauteile, wie beispielsweise ICs, passive und aktive Bauteile tragen. So können weitere Funktionalitäten bereitgestellt werden.

Der Stecker könnte einen Stift aufweisen, der mit dem Stecker und dem Stromlenkungsmittel verlötet ist, wobei das Stromlenkungsmittel mit der flexiblen Leiterplatte verlötet ist. Hierdurch sind eine verliersichere Anbindung des Steckers und eine gute elektrische Kontaktierung des Stifts sicher gestellt.

Die flexible Leiterplatte könnte Leiterbahnen aufweisen, die in Leiterbahnanschlüsse münden, welche am Rand der flexiblen Leiterplatte angeordnet sind und/ oder an deren Rand enden, wobei sich eine erste Leiterbahn von einem ersten Leiterbahnanschluss zu einem Eingangsanschluss erstreckt, wobei sich eine zweite Leiterbahn von einem Ausgangsanschluss zu einem zweiten Leiterbahnanschluss erstreckt, und wobei der Eingangsanschluss und der Ausgangsanschluss elektrisch leitend miteinander verbunden oder verbindbar sind. An den Leiterbahnanschlüssen oder auch Kontaktierungsflächen, die am Rand einer Folie oder in laschenartigen Auskragungen der Folie angeordnet sind, sind die Leiterbahnen elektrisch gut kontaktierbar. Es ist auch denkbar, dass sich Leiterbahnanschlüsse innerhalb der Leiterplatte befinden.

In der Zeichnung zeigen
- Fig. 1a: eine perspektivische Ansicht einer Leitertafel, nämlich einer PCB,
- Fig. 1b: eine weitere Darstellung der Leitertafel gemäß Fig. 1a, wobei auf Schwarzflächen verzichtet ist,
- Fig. 2a: eine flexible Leiterplatte, deren Leiterbahnen in einem Anbindungsbereich unterbrochen sind,
- Fig. 2b: eine weitere Darstellung der flexiblen Leiterplatte gemäß Fig. 2a, wobei auf Schwarzflächen verzichtet ist,
- Fig. 3a: eine Darstellung der flexiblen Leiterplatte gemäß Fig. 2a, wobei diese in ihrem Anbindungsbereich mit einer Leitertafel, nämlich einer PCB verlötet ist,
- Fig. 3b: eine weitere Darstellung der flexiblen Leiterplatte gemäß Fig. 3a, welche in ihrem Anbindungsbereich mit einer Leitertafel, nämlich einer PCB verlötet ist, wobei auf Schwarzflächen verzichtet ist,
- Fig. 4a: eine Darstellung der Anordnung gemäß Fig. 3a, wobei auf das Stromlenkungsmittel ein Stecker aufgesteckt ist,
- Fig. 4b: eine weitere Darstellung der Anordnung gemäß Fig. 3a, wobei auf Schwarzflächen verzichtet ist,
- Fig. 5: eine Schnittansicht einer Anordnung, bei welcher ein Versteifungskörper zwischen einem Stecker und einer flexiblen Leiterplatte angeordnet ist, und
- Fig. 6: eine Schnittansicht einer Anordnung, bei welcher eine Leitertafel mit einer flexiblen Leiterplatte verlötet ist, wobei der Stecker auf die Leitertafel aufgesteckt ist.

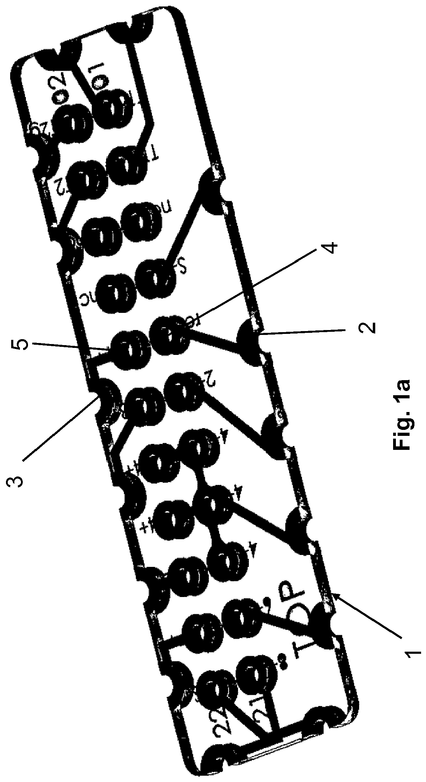

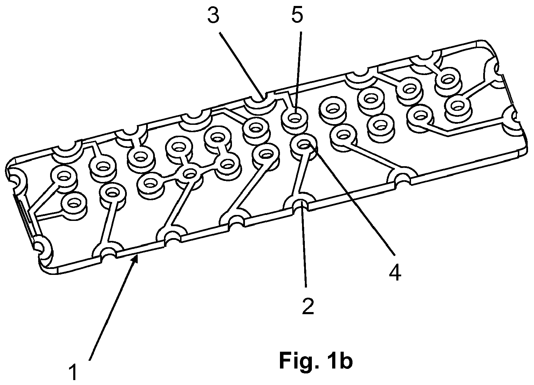

Fig. 1a und 1b zeigen eine Leitertafel 1, nämlich eine PCB, die mindestens einen Eingangsanschluss 2 und mindestens einen Ausgangsanschluss 3 für je eine Leiterbahn einer flexiblen Leiterplatte aufweist. Die Leitertafel 1 weist Stiftaufnahmen 4, 5 auf, wobei mindestens eine erste Stiftaufnahme 4 mit dem Eingangsanschluss 2 elektrisch leitend verbunden ist und wobei mindestens eine zweite Stiftaufnahme 5 mit dem Ausgangsanschluss 3 elektrisch leitend verbunden ist.

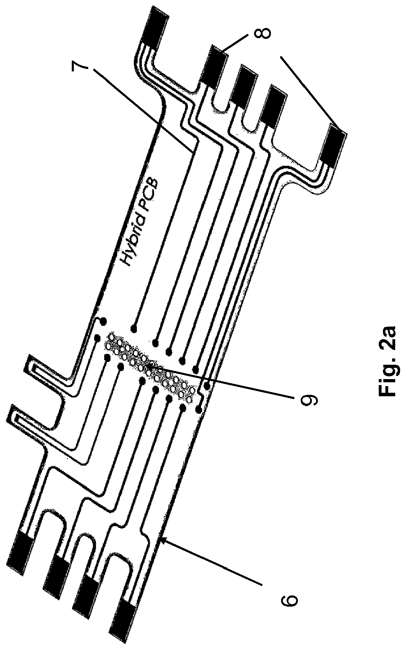

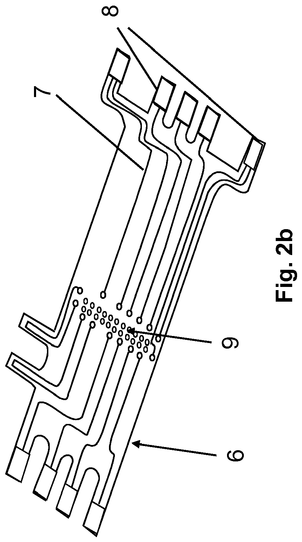

Fig. 2a und 2b zeigen eine flexible Leiterplatte 6, welche Leiterbahnen 7 aufweist, die in Leiterbahnanschlüsse 8 münden, welche am Rand der flexiblen Leiterplatte 6 angeordnet sind und an deren Rand enden. Die Leiterbahnen 7 sind in einem Anbindungsbereich 9 unterbrochen.

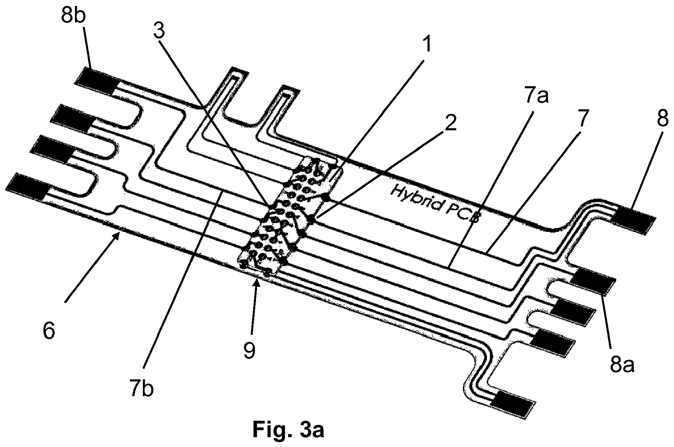

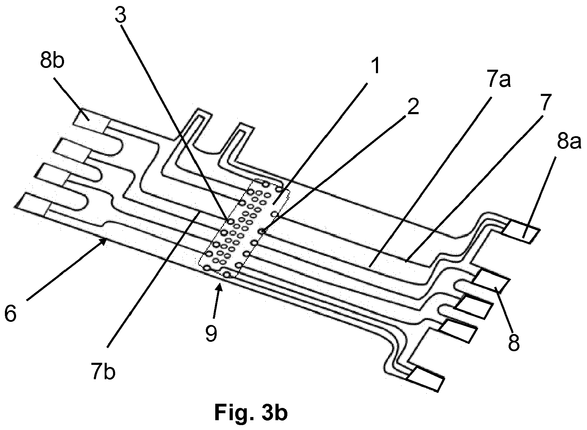

Fig. 3a und 3b zeigen eine Anordnung, umfassend eine flexible Leiterplatte 6 mit Leiterbahnen 7 und ein Stromlenkungsmittel, nämlich eine Leitertafel 1, welche mit der flexiblen Leiterplatte 6 an einem Anbindungsbereich 9 verbunden ist.

Das Stromlenkungsmittel weist mindestens einen Eingangsanschluss 2 für eine erste Leiterbahn 7a auf, wobei das Stromlenkungsmittel einen Ausgangsanschluss 3 für eine zweite Leiterbahn 7b aufweist und wobei die beiden Leiterbahnen 7a, 7b durch das Stromlenkungsmittel miteinander elektrisch leitend verbindbar sind.

Die erste Leiterbahn 7a ist mit der zweiten Leiterbahn 7b elektrisch leitend verbindbar, ohne dass eine weitere Leiterbahn 7 der flexiblen Leiterplatte 6 durch die elektrische Verbindung gekreuzt oder überquert ist.

Es erfolgt eine Entflechtung der Leiterbahnen 7, 7a, 7b durch die Leitertafel 1, nämlich durch die PCB, so dass durch die elektrische Verbindung der Leiterbahnen 7a und 7b keine weitere Leiterbahn 7 überkreuzt wird.

Das Stromlenkungsmittel ist als Leitertafel 1 ausgestaltet, welche biegesteifer als die flexible Leiterplatte 6 ist. Konkret ist die Leitertafel als PCB ausgestaltet, wie sie in den Fig. 1a und 1b dargestellt ist. Das Stromlenkungsmittel ist durch eine stoffschlüssige Verbindung mit der flexiblen Leiterplatte 6 verbunden.

Die flexible Leiterplatte 6 weist Leiterbahnen 7, 7a, 7b auf, die in Leiterbahnanschlüsse 8, 8a, 8b münden, welche am Rand der flexiblen Leiterplatte 6 angeordnet sind und an deren Rand enden.

Eine erste Leiterbahn 7a erstreckt sich von einem ersten Leiterbahnanschluss 8a zu einem Eingangsanschluss 2, wobei sich eine zweite Leiterbahn 7b von einem Ausgangsanschluss 3 zu einem zweiten Leiterbahnanschluss 8b erstreckt und wobei der Eingangsanschluss 2 und der Ausgangsanschluss 3 elektrisch leitend miteinander verbunden oder verbindbar sind.

Der erste Leiterbahnanschluss 8a und der zweite Leiterbahnanschluss 8b sind an örtlich verschiedenen Stellen der flexiblen Leiterplatte 6 positioniert.

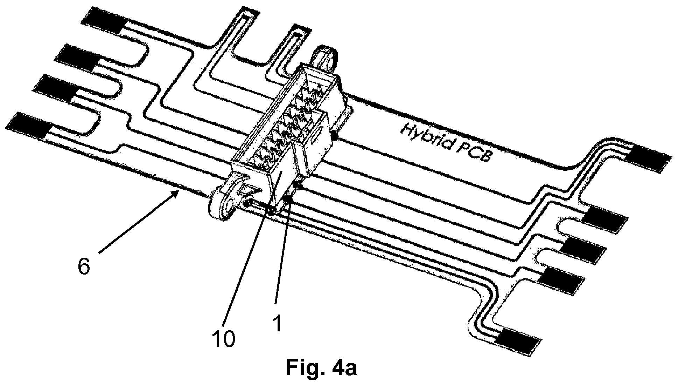

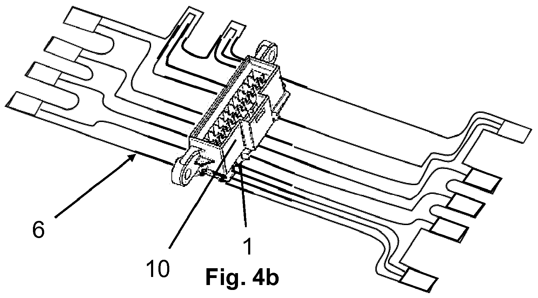

Fig. 4a und 4b zeigen, dass das Stromlenkungsmittel einen Stecker 10 trägt, welcher in das Stromlenkungsmittel, nämlich die Leitertafel 1, eingesteckt ist. Der Stecker 10 ist als Steckverbinder ausgestaltet, der in der Leitertafel 1 und in der Leiterplatte 6 verankert wird. Der Stecker 10 ist als THT-Bauteil ("throughhole-technic") verlötet und mit der flexiblen Leiterplatte 6 verbunden.

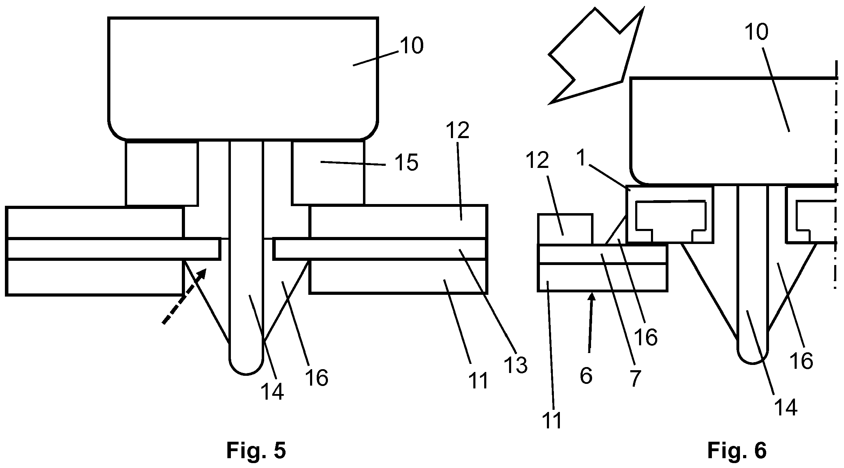

Fig. 5 zeigt einen Verbund, umfassend eine Basislage 11 aus Polyethylennaphthalat (PEN) und eine Decklage 12 aus Polyethylennaphthalat (PEN), wobei die Basislage 11 und die Decklage 12 jeweils eine Dicke von 50 µm aufweisen und wobei die Basislage 11 und die Decklage 12 zwischen sich eine Leiterlage 13 aus Kupfer sandwichartig aufnehmen. Die Leiterlage 13 weist eine Dicke von 70 µm auf.

Ein Stecker 10 mit einem Stift 14 schließt zwischen seinem Grundkörper und der Decklage 12 einen Versteifungskörper 15 aus FR4 ein. FR4 ist die Bezeichnung für eine Klassifizierung von schwer entflammbaren und flammenhemmenden Verbundwerkstoffen. Der Versteifungskörper 15 ist nicht elektrisch leitend. Der Versteifungskörper 15 ist als FR4 0,8T ausgestaltet und ist Träger des Steckers 10 des Typs PTH (22P CN).

Der Stift 14 durchgreift einen Durchgang sowohl der Basislage 11, Decklage 12 und Leiterlage 13, wobei die Leiterlage 13 mit Randstegen oder einem Rand in eine Aussparung der Basislage 11 und Decklage 12 hineinragt, die größer ist als der gemeinsame Durchgang.

Ein Lötmittel 16 umgibt den Stift 14 auf der Seite der Basislage 11 und innerhalb der Leiterlage 13. Das Lötmittel 16 liegt sowohl innerhalb des Durchgangs an der Leiterlage 13 an, als auch an der Randseite, die der Basislage 11 zugewandt ist. Üblicherweise wird ein Laser eingesetzt, um Durchgänge und Ausnehmungen zu erzeugen.

Fig. 6 zeigt, dass durch ein Lötverfahren auf den Einsatz eines Lasers verzichtet werden kann. Eine Leitertafel 1 wird an eine flexible Leiterplatte 6 elektrisch leitend angelötet und mechanisch fixiert. Die Leitertafel 6 dient zugleich als Träger für eine elektrische Kontaktierung.

Fig. 6 zeigt konkret, dass der Stecker 10 einen Stift 14 aufweist, der mit dem Stecker 10 und dem Stromlenkungsmittel, nämlich der Leitertafel 1, durch Lötmittel 16 verlötet ist, wobei das Stromlenkungsmittel mit der flexiblen Leiterplatte 6 verlötet ist.

Die Leitertafel 1 ist eine doppelseitige PCB der Dicke 0,8 mm. Die Leitertafel 1 ist an der einseitig freigelegten flexiblen Leiterplatte 6 und dem Stecker 10 des Typs PTH (22P CN) angelötet. Die Leiterbahn 7 weist eine Dicke von 35 µm auf und besteht aus Kupfer.

Die Leiterbahn 7 liegt auf einer Basislage 11 aus Polyethylennaphthalat (PEN) an, welche 50 µm dick ist. Die durch Freilegung abgetragene Decklage 12 besteht ebenfalls aus Polyethylennaphthalat (PEN) und weist auch eine Dicke von 50 µm auf. Das Lötmittel 16 liegt an der Leiterbahn 7 an.

### Bezugszeichenliste:

- 1: Leitertafel
- 2: Eingangsanschluss
- 3: Ausgangsanschluss
- 4: Stiftaufnahme
- 5: Stiftaufnahme
- 6: Flexible Leiterplatte
- 7: Leiterbahn
- 7a: erste Leiterbahn
- 7b: zweite Leiterbahn
- 8: Leiterbahnanschluss
- 8a: erster Leiterbahnanschluss
- 8b: zweiter Leiterbahnanschluss
- 9: Anbindungsbereich
- 10: Stecker
- 11: Basislage
- 12: Decklage
- 13: Leiterlage
- 14: Stift
- 15: Versteifungskörper
- 16: Lötmittel

## Patentansprüche

1. Anordnung, umfassend eine flexible Leiterplatte (6) mit Leiterbahnen (7, 7a, 7b) und ein Stromlenkungsmittel, welches mit der flexiblen Leiterplatte (6) an einem Anbindungsbereich (9) verbunden ist,
wobei das Stromlenkungsmittel mindestens einen Eingangsanschluss (2) für eine erste Leiterbahn (7a) aufweist, wobei das Stromlenkungsmittel einen Ausgangsanschluss (3) für eine zweite Leiterbahn (7b) aufweist und wobei die beiden Leiterbahnen (7a, 7b) durch das Stromlenkungsmittel miteinander elektrisch leitend verbindbar oder verbunden sind.

2. Anordnung nach Anspruch 1, **dadurch gekennzeichnet, dass** die erste Leiterbahn (7a) mit der zweiten Leiterbahn (7b) elektrisch leitend verbindbar oder verbunden ist, ohne dass eine weitere Leiterbahn (7) der flexiblen Leiterplatte (6) durch die elektrische Verbindung gekreuzt oder überquert ist.

3. Anordnung nach Anspruch 1 oder 2, **dadurch gekennzeichnet, dass** das Stromlenkungsmittel als Leitertafel (1) ausgestaltet ist, welche biegesteifer als die flexible Leiterplatte (6) ist.

4. Anordnung nach Anspruch 3, **dadurch gekennzeichnet, dass** die Leitertafel (1) Stiftaufnahmen (4, 5) aufweist, wobei mindestens eine erste Stiftaufnahme (4) mit dem Eingangsanschluss (2) elektrisch leitend verbunden ist und wobei mindestens eine zweite Stiftaufnahme (5) mit dem Ausgangsanschluss (3) elektrisch leitend verbunden ist.

5. Anordnung nach Anspruch 1, **dadurch gekennzeichnet, dass** das Stromlenkungsmittel als weitere flexible Leiterplatte ausgestaltet ist.

6. Anordnung nach einem der voranstehenden Ansprüche, **dadurch gekennzeichnet, dass** das Stromlenkungsmittel durch eine stoffschlüssige Verbindung mit der flexiblen Leiterplatte (6) verbunden ist.

7. Anordnung nach einem der voranstehenden Ansprüche, **dadurch gekennzeichnet, dass** das Stromlenkungsmittel elektronische Bauteile und/ oder einen Stecker (10) trägt, welcher in das Stromlenkungsmittel reversibel oder irreversibel eingesteckt ist.

8. Anordnung nach Anspruch 7, **dadurch gekennzeichnet, dass** der Stecker (10) einen Stift (14) aufweist, der mit dem Stecker (10) und dem Stromlenkungsmittel verlötet ist, wobei das Stromlenkungsmittel mit der flexiblen Leiterplatte (6) verlötet ist.

9. Anordnung nach einem der voranstehenden Ansprüche, **dadurch gekennzeichnet, dass** die flexible Leiterplatte (6) Leiterbahnen (7, 7a, 7b) aufweist, die in Leiterbahnanschlüsse (8, 8a, 8b) münden, welche am Rand der flexiblen Leiterplatte (6) angeordnet sind und/ oder an deren Rand enden, wobei sich eine erste Leiterbahn (7a) von einem ersten Leiterbahnanschluss (8a) zu einem Eingangsanschluss (2) erstreckt, wobei sich eine zweite Leiterbahn (7b) von einem Ausgangsanschluss (3) zu einem zweiten Leiterbahnanschluss (8b) erstreckt, und wobei der Eingangsanschluss (2) und der Ausgangsanschluss (3) elektrisch leitend miteinander verbunden oder verbindbar sind.
